Europäisches Patentamt

European Patent Office

Office européen des brevets

(11) Veröffentlichungsnummer: **0 221 514 B1**

# EUROPÄISCHE PATENTSCHRIFT

(45) Veröffentlichungstag der Patentschrift: **07.01.93**

(21) Anmeldenummer: **86115089.4**

(22) Anmeldetag: **30.10.86**

(51) Int. Cl.⁵: **G02B 5/18**, G02B 5/32, G03F 7/20

(54) Verfahren zur Erzeugung einer Gitterstruktur mit Phasensprung auf der Oberfläche eines Substrats.

(30) Priorität: **04.11.85 DE 3539092**
**19.12.85 DE 3545102**

(43) Veröffentlichungstag der Anmeldung:
**13.05.87 Patentblatt 87/20**

(45) Bekanntmachung des Hinweises auf die
Patenterteilung:
**07.01.93 Patentblatt 93/01**

(84) Benannte Vertragsstaaten:
**DE FR GB NL**

(56) Entgegenhaltungen:
**EP-A- 0 140 594**

**ELECTRONIC LETTERS, Band 20, Nr. 24, 22. November 1984, Seten 1008-1010; K. UTAKA et al.: "Lambda/4-shifted InGaAsP/InP DFB lasers by simultaneous holographic exposure of positive and negative photoresists"**

**APPLIED PHYSICS LETTERS, Band 47, Nr. 3, 1. August 1985, Seiten 269-271, American Institute of Physics; R.M. LUM et al.: "Improvements in the modulation amplitude of submicron gratings produced in n-InP by**

**direct photoelectrochemical etching"**

**APPLIED OPTICS, Band 24, Nr. 19, 1. Oktober 1985, Seiten 3155-3161, Optical Society of America; X. MAI et al.: "Simple versatile method for fabricating guided-wave gratings"**

(73) Patentinhaber: **SIEMENS AKTIENGESELL-SCHAFT**
**Wittelsbacherplatz 2**
**W-8000 München 2(DE)**

(72) Erfinder: **Heise, Gerhard, Dipl.-Phys.**
**Bert-Brecht-Allee 10**
**W-8000 München 83(DE)**
Erfinder: **Wolff, Ulrich, Dipl.-Phys.**
**Geigenberger Strasse 357**
**W-8000 München 71(DE)**
Erfinder: **Matz, Richard, Dr.**
**Naringerstrasse 24a**
**W-8152 Feldkirchen(DE)**

## Beschreibung

Die Erfindung betrifft ein Verfahren zur Erzeugung einer Gitterstruktur mit Phasensprung auf einer Oberfläche eines Substrats nach dem Oberbegriff des Patentanspruchs 1.

Für die optische Nachrichtentechnik werden zur Erzielung hoher Datenraten auf langen Übertragungsstrecken spezielle Halbleiterlaser benötigt, die auch bei hoher Modulationsfrequenz in einem einzigen longitudinalen Schwingungsmodus emittieren. Ein grundsätzlich geeigneter Typ ist der Laser mit verteilter Rückkopplung (DFB-Laser, DFB ist die Abkürzung für "distributed feedback"), bei dem die Rückkopplung des Lichtes im Laser-Resonator nicht durch zwei Spiegel sondern durch ein der ganzen Laserstruktur überlagertes Reflexionsgitter erfolgt. Im allgemeinen schwingt aber ein DFB-Laser nicht nur in einem Modus, sondern in zwei Moden. Einmodige Lichtemission läßt sich jedoch erzwingen, unter anderem durch Aufteilung der Gitterstruktur in zwei Teilgitter, deren Phase gegeneinander um eine halbe Gitterkonstante, d.h. um ein Viertel der Lichtwellenlänge, verschoben ist. Solche DFB-Laser mit Phasensprung werden beispielsweise in H.A: Haus, C.V. Shank: Antisymmetric Taper of Distributed Feedback Laser, IEEE J. Quant. Electr. QE-12 (1976) S. 532-539 beschrieben.

Gitterstrukturen für DFB-Laser werden heute zum überwiegenden Teil durch holografische Lithografie, d.h. durch Belichtung einer auf der Oberfläche des Lasersubstrats aus Halbleitermaterial aufgebrachten Fotolackschicht in einem optischen Interferenzfeld, Entwickeln der Schicht und Ätzen der mit der entwickelten Fotolackschicht bedeckten Oberfläche erzeugt, wobei in der Oberfläche des Substrats eine reliefartige Gitterstruktur mit einer der Ortsfrequenz des Interferenzfeldes entsprechenden Ortsfrequenz entsteht. Die übrigen Schritte der Laserherstellung erfolgen in bekannter Weise.

Das optische Interferenzfeld wird durch optische Überlagerung zweier kohärenter Lichtwellen erzeugt. Dabei entstehen aber nur einfache Gitterstrukturen ohne Phasensprung.

Zur Erzeugung von Gitterstrukturen mit Phasensprung werden derzeit Elektronenstrahlschreiber eingesetzt (siehe beispeilsweise K. Sekartedjo et al: 1,5 $\mu$m phase-shifted DFB lasers for single-mode operation, Electr. Lett. 20 (1984) S. 80-81) oder holografische Lithografie-Verfahren mit kombiniertem Einsatz von Positiv- und Negativ-Fotolack (siehe K. Utaka et al: $\lambda$/4-shifted InGaAsP/InP DFB lasers by simultaneous holographic exposure of positive and negative photoresist, Electr. Lett. 20 (1984) S. 1008-1010).

Im erstgenannten Fall wird ein sehr kostspieliger Elektronenstrahlschreiber benötigt, im zweitgenannten Fall handelt es sich um ein technologisch aufwendiges Verfahren, das bei der Laserproduktion hohe Ausfallraten erwarten läßt.

In beiden Fällen ist die Gitterstrukturherstellung zeitraubend.

US-A-3 580 655 offenbart Gitterstrukturen, die auf einer Foto-Platte durch überlagerte Belichtung zweier Interferenzfelder unterschiedlicher Ortsfrequenz gebildet werden. In diesem Dokument sind aber Gitter mit parallelen Gitterlinien ausgeschlossen, deshalb ist es unmöglich, den Phasensprung gemäß Patentanspruch 1 zu erreichen.

Aufgabe der Erfindung ist es, ein besonders einfaches Verfahren zur Erzeugung einer Gitterstruktur mit Phasensprung, insbesondere von Gitterstrukturen für DFB-Laser anzugeben.

Diese Aufgabe wird ausgehend von einem Verfahren der eingangs genannten Art durch die im kennzeichnenden Teil des Patentanspruchs 1 angegebenen Merkmale gelöst.

Das erfindungsgemäße Verfahren unterscheidet sich danach von der derzeit üblichen holografischen Lithografie zur Herstellung einer Gitterstruktur ohne Phasensprung für DFB-Laser im wesentlichen lediglich durch eine überlagerte Belichtung der Fotolackschicht in wenigstens zwei optischen Interferenzfeldern unterschiedlicher Ortsfrequenz.

Das erfindungsgemäße Verfahren kann gemäß Anspruch 2 in Fotolacktechnik , aber auch gemäß Anspruch 3 in einer Technik des maskenlosen laseraktiven Ätzens (siehe beispielsweise R. M. Lum, F.W. Ostermayer Jr., P.A. Kohl, A.M. Glass, A.A. Ballman in Appl. Phys. Lett. 47 (3), Aug. 1985, S. 269-271) ausgeführt werden.

Drei besonders zweckmäßige Durchführungsmöglichkeiten des erfindungsgemäßen Verfahrens gehen aus den Unteransprüchen 4 bis 6 hervor.

Die Erfindung wird beispielhaft in der folgenden Beschreibung anhand der Figuren erläutert. Von den Figuren zeigen:

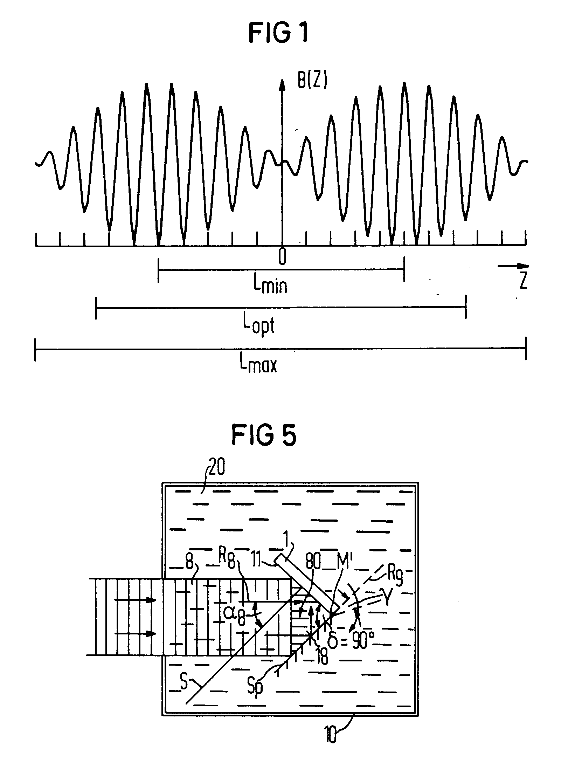

Figur 1 eine bestimmte Belichtungsfunktion B(Z) zur Erzeugung einer Gitterstruktur eines DFB-Lasers, wobei die auf diese Funktion bezogene minimale Länge $L_{min}$, optimale Länge $L_{opt}$ und maximale Länge $L_{max}$ des Lasers angegeben sind,

Figur 2 die Belichtung einer Fotolackschicht auf der Oberfläche des Substrats in dem optischen Interferenzfeld zweier optisch überlagerter ebener kohärenter Lichtwellen;

Figur 3 die Belichtung der Fotolackschicht auf der Oberfläche des Substrats in dem Interferenzfeld zweier optisch überlagerter divergenter kohärenter Lichtwellen,

Figur 4     die Belichtung der Fotolackschicht auf der Oberfläche des Substrats in dem Interferenzfeld einer ebenen Lichtwelle und einem mit dieser optisch überlagerten und von einem Spiegel umgelenkten Anteil dieser Welle, und

Figur 5     die Belichtung einer mit einer durch Belichtung aktivierbaren Ätzflüssigkeit in Kontakt stehenden Oberfläche des Substrats in dem Interferenzfeld einer ebenen Lichtwelle und einem mit dieser optisch überlagerten und von einem Spiegel umgelenkten Anteil dieser Welle.

Im folgenden wird beispielhaft angenommen, daß die fotoempfindliche Oberflächenschicht des Substrats, d.h. die Fotolackschicht bzw. die mit der Ätzflüssigkeit in Kontakt stehende Oberfläche des Substrats, in einem Interferenzfeld doppelbelichtet wird, wobei zwischen den einzelnen Belichtungen die Ortsfrequenz K des Interferenzfeldes um einen kleinen Betrag $2\Delta K$ verändert wird.

Die Belichtungsfunktion $B_1(Z)$ der ersten Belichtung, d.h. die Ortsabhängigkeit der Lichtintensität in Z-Richtung auf der fotoempfindlichen Schicht betrage beispielsweise etwa

$$B_1(Z) = B_0 (1 + \sin (K + \Delta K)Z). \qquad (1)$$

Die Belichtungsfunktion der zweiten Belichtung betrage

$$B_2(Z) = B_0 (1 - \sin (K - \Delta K)Z). \qquad (2)$$

Die Belichtungsfunktion der Gesamtbelichtung ist gegeben durch

$$B(Z) = B_1(Z) + B_2(Z) = B_0 (2 + \sin(K+\Delta K)Z - \sin(K-\Delta K)Z) = \qquad (3)$$
$$= B_0 (2 + 2\sin(\Delta K \cdot Z)\cos(K \cdot Z))$$

Dies ist eine Belichtungsfunktion mit der Ortsfrequenz K moduliert mit der Modulationsfunktion $\sin \Delta K \cdot Z$. Der Vorzeichenwechsel der Modulationsfunktion an den Stellen $\Delta K \cdot Z = N \cdot \pi$ läßt sich auch als Phasensprung der modulierten Funktion an diesen Z-Werten interpretieren:

$$\frac{B(Z)}{B_0} = 2 + 2 \cdot |\sin \Delta K \cdot Z| = \begin{cases} \cos K \cdot Z & \text{für } 2N\frac{\pi}{\Delta K} < Z \leq (2N+1)\frac{\pi}{\Delta K} \\ \cos(K \cdot Z + \pi) & \text{für } (2N-1)\frac{\pi}{\Delta K} < Z < 2N\frac{\pi}{\Delta K} \end{cases}, \qquad (4)$$
$$N \text{ ganzzahlig.}$$

Die Belichtungsfunktion B(Z) ist also eine Gitterfunktion mit Phasensprüngen im Abstand $\Delta z = \pi /\Delta K$.

Die belichtete Fotolackschicht wird entwickelt und die Gitterstruktur durch Ätzen in das Halbleitermaterial des Substrats übertragen. Die übrigen Schritte der Laserherstellung erfolgen ebenfalls in bekannter Weise.

Die Länge L des Lasers wird so gewählt, daß ein Phasensprung in die Mitte des Lasers fällt, und daß L nicht größer als die Periode $L_{max} = 2\pi/\Delta K$ der Modulationsfunktion $\sin \Delta K \cdot Z$ wird; auf der anderen Seite soll die maximale Modulationstiefe des Gitters noch im Laser erreicht werden, also L nicht kleiner sein als die halbe Periode $L_{min}$ der Modulationsfunktion, also

$$\frac{\pi}{\Delta K} \leq L \leq \frac{2\pi}{\Delta K} \qquad (5)$$

gelten.

Vorzugsweise wird das Produkt $L \cdot K = L_{opt} \cdot K$ etwa 4,6 gewählt.

Für eine vorgegebene Laserlänge L von beispielsweise etwa 500 $\mu$m ergibt sich daraus für die Ortsfrequenzveränderung $2\Delta K/2\pi$ zwischen den beiden Belichtungen ein Wert von etwa drei Linien/mm.

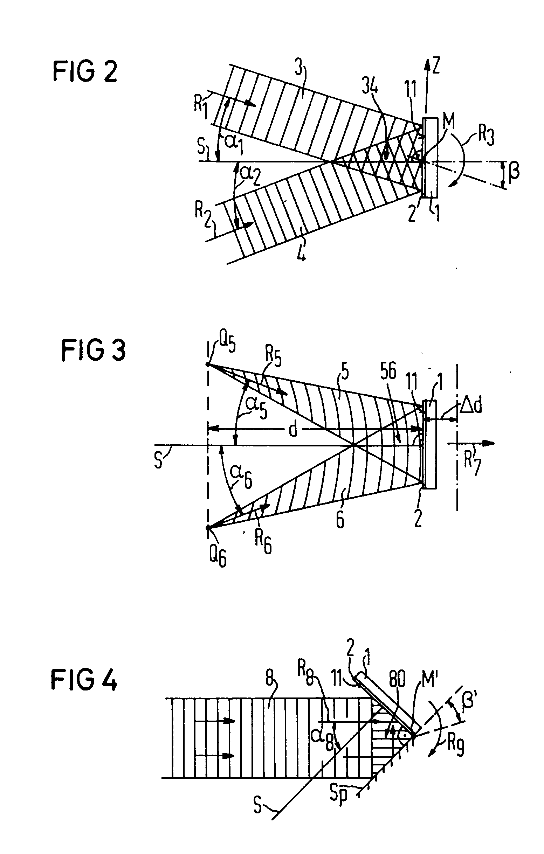

Im folgenden werden drei zweckmäßige und vorteilhafte Ausführungsformen der Doppelbelichtung der fotoempfindlichen Oberflächenschicht des Substrats anhand der Figuren 2 bis 5 beschrieben.

In diesen Figuren ist das Substrat mit 1, dessen Oberfläche mit 11, und ein auf die Oberfläche 11 gefälltes Lot mit S bezeichnet. Die Einfallsebene, in der die optisch überlagerten Lichtwellen einfallen, ist bei sämtlichen Figuren 2 bis 5 die Zeichenebene.

In den Figuren 2 bis 4 besteht die fotoempfindliche Oberflächenschicht des Substrats 1 aus einer auf die Oberfläche 11 aufgebrachten Fotolackschicht 2.

Nach Figur 2 überlagern sich zwei aus verschiedenen Richtungen $R_1$ und $R_2$ einfallende kohärente ebene Wellen 3, 4 vor der Fotolackschicht 2 und bilden ein Interferenzfeld 34, das auf dieser Fotolackschicht 2 parallele, senkrecht zur Zeichenebene verlaufende Interferenzstreifen erzeugt. Die Ortsfrequenz K dieser Interferenzstreifen läßt sich durch den Einfallswinkel der ebenen Wellen und deren Wellenlänge weitgehend einstellen. Der Einfallswinkel der ebenen Welle 3 bzw. 4 ist bekanntlich durch den zwischen der zugeordneten Richtung $R_1$ bzw. $R_2$ und dem Lot S gemessenen Winkel $\alpha_1$ bzw. $\alpha_2$ gegeben.

Der Fotolack 2 wird eine ausreichende Belichtungszeit lang mit diesen Interferenzstreifen belichtet.

Für die zweite Belichtung wird der Einfallswinkel $\alpha_1$ und/oder $\alpha_2$ der ebenen Wellen 3 und 4 geändert. Dies geschieht am einfachsten dadurch, daß das Substrat um eine zur Einfallsebene senkrechte Achse M verdreht wird, beispielsweise in Richtung des Pfeiles $R_3$, wobei in diesem Fall die geänderten Einfallswinkel gegeben sind durch $\alpha_1 + \beta$ und $\alpha_2 - \beta$. Dadurch ändert sich von selbst die Ortsfrequenz K der Interferenzstreifen auf der Fotolackschicht 2. Die erforderliche Ortsfrequenzänderung $\Delta K$ läßt sich durch den Betrag des Winkels $\beta$, um den verdreht wird, einstellen. Die Lage der Drehachse M ist relativ unkritisch.

Nach Figur 3 überlagern sich zwei von Quellpunkten oder -linien Q5, Q6 ausgehende, aus verschiedenen Richtungen $R_5$ bzw. $R_6$ einfallende kohärente divergente Wellen 5, 6 vor der Fotolackschicht 2. Sie bilden ein Interferenzfeld 56, das ebenfalls Interferenzstreifen auf der Fotolackschicht 2 erzeugt. Bei vorgegebenen Einfallswinkeln $\alpha_5$ bzw. $\alpha_6$ der divergenten Wellen 5, 6 läßt sich die Ortsfrequenz K dieser Interferenzstreifen durch den Abstand d der Fotolackschicht 2 von den Quellpunkten $Q_5$, $Q_6$ weitgehend einstellen.

Ist der Abstand d für die eine Belichtung ausgewählt, so wird für die zweite Belichtung dieser Abstand d durch Verschieben in der beispielsweise zum Lot S parallelen Richtung $R_7$ vergrößert oder aber auch verkleinert. Dadurch ändert sich von selbst die Ortsfrequenz der Interferenzstreifen auf der Fotolackschicht 2. Die erforderliche Ortsfrequenzänderung $\Delta K$ läßt sich durch die Abstandsänderung $\Delta d$ einstellen.

Nach Figur 4 ist das Substrat 1 fest mit einem im Winkel $\delta$ von beispielsweise 90° dazu angeordneten ebenen Spiegel Sp verbunden. Aus Richtung $R_8$ fällt eine ebene Welle 8 sowohl auf die Fotolackschicht 2 als auch auf den Spiegel Sp. Der Spiegel Sp reflektiert den auf ihn treffenden Anteil 18 der ebenen Welle 8, beispielsweise die Hälfte, in Richtung Fotolackschicht 2. Dadurch entsteht vor der Fotolackschicht 2 ein Interferenzfeld 80, das auf dieser Schicht Interferenzstreifen erzeugt, deren Ortsfrequenz K vom Einfallswinkel $\alpha_8$ der ebenen Welle auf die Fotolackschicht 2 sowie vom Winkel $\delta$ zwischen dem Spiegel Sp und der Fotolackschicht 2 bzw. Oberfläche 11 abhängt.

Ist die Ortsfrequenz K für die eine Belichtung ausgewählt, so kann die Ortsfrequenzänderung $\Delta K$ für die zweite Belichtung einfach durch gemeinsames Verdrehen von Substrat 1 und Spiegel Sp um eine Achse M', beispielsweise in Richtung des Pfeiles $R_9$, eingestellt werden. Wie bei der Ausgestaltung nach Figur 2 läßt sich die erforderliche Ortsfrequenzänderung $\Delta K$ durch den Betrag des Winkels $\gamma$, um den verdreht wird, einstellen. Auch hier ist die Lage der Drehachse M' relativ unkritisch.

In der Figur 5 besteht die fotoempfindliche Oberflächenschicht des Substrats 1 aus dessen mit einer durch Belichtung aktivierbaren Ätzflüssigkeit 20 in Kontakt stehenden Oberfläche 11 selbst. Ansonsten entspricht die ganze Anordnung nach Figur 5 der Anordnung nach Figur 4, wobei die einander entsprechenden Elemente die gleichen Bezugszeichen aufweisen. Im Unterschied zur Figur 4 ist die Anordnung nach Figur 5 in einer die Ätzflüssigkeit 20 enthaltenden transparenten Küvette 10 eingeschlossen.

Durch das einfallende Laserlicht 8 wird eine chemische Reaktion direkt im Substratmaterial an der Oberfläche 11 des Substrats 1 ausgelöst. Die Entstehung des Gitters mit Phasensprung läuft ganz analog ab, wie bei der Verwendung von Fotolack: Im ersten Belichtungsschritt wird beispielsweise ein Gitter mit einer ersten Gitterkonstanten $K = \Lambda + \Delta\Lambda$, zweiten Belichtungsschritt ein Gitter mit der Gitterkonstanten $\Lambda - \Delta\Lambda$ erzeugt. Das aus der Überlagerung dieser beiden Gitter resultierende Gitter hat eine mittlere Gitterkonstante $\Lambda$, die sinusförmig mit der Periode $\Delta\Lambda$ moduliert ist.

Als Ätzmittel kommen alle für laseraktives Ätzen bekannten Flüssigkeiten und Gase in Betracht. So kann beispielsweise eine Mischung aus einem Teil $H_2SO_4$, einem Teil $H_2O_2$ und 10 Teilen $H_2O$ (siehe obengenannte Literaturstelle Appl. Phys. Lett.) verwendet werden, die beispielsweise für ein Substratmaterial aus InP geeignet ist.

Für die Herstellung der Gitterstrukturen durch laseraktives Ätzen und die Herstellung mittels Fotolack kann die gleiche optische Anordnung zur Belichtung verwendet werden. So kann bei dem Verfahren nach Figur 5 anstelle der Anordnung nach Figur 4 auch die Anordnung nach Figur 2 oder Figur 3 verwendet werden.

Bezugszeichenliste
_____

| | |
|---|---|
| B(Z) | Belichtungsfunktion |
| $L_{min}$ | minimale Länge des Lasers |
| $L_{max}$ | maximale Länge des Lasers |
| $L_{opt}$ | optimale Länge des Lesers |
| 1 | Substrat |
| 11 | Oberfläche des Substrats |
| 2 | Fotolackschicht |
| S | auf die Oberfläche gefälltes Lot |
| $R_1$, $R_2$ | verschiedene Richtungen |
| 3, 4 | kohärente ebene Wellen |
| 34 | Interferenzfeld |
| K | Ortsfrequenz der Interferenzstreifen |
| $\alpha_1$, $\alpha_2$ | Einfallswinkel der ebenen Wellen |
| M | zur Einfallsebene senkrechte Achse |
| $R_3$ | Pfeil |
| $\beta$ | Winkel, um den das Substrat 1 um die Achse M verdreht wird |
| $Q_5$, $Q_6$ | Quellpunkte oder -linien |
| $R_5$, $R_6$ | einfallende divergente Wellen |
| 5, 6 | kohärente divergente Wellen |
| $\alpha_5$, $\alpha_6$ | Einfallswinkel der divergenten Wellen 5, 6 |
| d | Abstand der Fotolackschicht von den Quellpunkten $Q_5$, $Q_6$ |
| $R_7$ | Richtung parallel zum Lot S |
| $\Delta d$ | Abstandsänderung |
| $\delta$ | Winkel, in dem der Spiegel Sp zum Substrat 1 angeordnet ist |
| Sp | Spiegel |
| $R_8$ | Richtung |
| 8 | ebene Welle |
| 18 | vom Spiegel Sp reflektierter Anteil der ebenen Welle 8 |
| 80 | Interferenzfeld |
| $\alpha_8$ | Einfallswinkel der ebenen Welle 8 |
| M' | Achse |
| $R_9$ | Pfeil |
| $\gamma$ | Winkel, um den verdreht wird |
| 20 | Ätzflüssigkeit |
| 10 | Küvette |
| $\Lambda$ | Gitterkonstante |
| $\Delta\Lambda$ | Periode, mit der die Gitterkonstante moduliert ist |

**Patentansprüche**

1. Verfahren zur Erzeugung einer Gitterstruktur mit Phasensprung in einer photoempfindlichen Oberflächenschicht (2, 11) auf einem Substrat (1),
wobei die photoempfindliche Oberflächenschicht (2, 11) in einem Interferenzfeld zweier Kohäreuter Lichtwellen, das in einer bestimmten, zur photoempfindlichen Oberflächenschicht (2, 11) parallelen Richtung (Z) eine bestimmte, von null verschiedene Ortsfrequenz (K+$\Delta$K; K-$\Delta$K) aufweist, belichtet wird,
wobei die photoempfindliche Oberflächenschicht (2, 11) in zumindest einem weiteren Interferenzfeld zweier Kohäreuter Lichtwellen, das in der bestimmten Richtung (Z) eine von null sowie von der bestimmten Ortsfrequenz (K+$\Delta$K; K-$\Delta$K) verschiedene Ortsfrequenz (K+$\Delta$K; K-$\Delta$K) aufweist, belichtet wird und
wobei die photoempfindliche Oberflächenschicht (2, 11) nach den Belichtungen in diesen Interferenzfeldern entwickelt wird.

**EP 0 221 514 B1**

2. Verfahren nach Anspruch 1, **dadurch gekennzeichnet,** daß die fotoempfindliche Oberflächenschicht des Substrats (1) aus einer auf das Substrat (1) aufgebrachten Fotolackschicht (2) besteht, die nach den überlagerten Belichtungen entwickelt wird, wobei die mit der entwickelten Fotolackschicht bedeckte Oberfläche (11) des Substrats mit einem Ätzmittel geätzt wird, das die Oberfläche (11) des Substrats angreift.

3. Verfahren nach Anspruch 1, **dadurch gekennzeichnet,** daß die fotoempfindliche Oberflächenschicht aus der mit einem Ätzmittel (20) in Kontakt stehenden Substratoberfläche (11) besteht, an der die Ätzreaktion durch Belichtung aktivierbar ist.

4. Verfahren nach einem der vorhergehenden Ansprüche, **dadurch gekennzeichnet,** daß die fotoempfindliche Oberflächenschicht (2, 11) in dem Interferenzfeld (34) zweier ebener kohärenter Wellen (3, 4) unter verschiedenen Einfallswinkeln belichtet wird.

5. Verfahren nach einem der Ansprüche 1 bis 3, **dadurch gekennzeichnet,** daß die fotoempfindliche Oberflächenschicht (2, 11) in dem Interferenzfeld (56) zweier divergenter kohärenter Lichtwellen (5, 6) in verschiedenen Abständen von den Quellpunkten oder -linien ($Q_5$, $Q_6$) der divergenten Wellen (5, 6) belichtet wird.

6. Verfahren nach einem der Ansprüche 1 bis 3, **dadurch gekennzeichnet,** daß die fotoempfindliche Oberflächenschicht (2, 11) in dem Interferenzfeld (80) einer ebenen Welle (8) und eines von einem relativ zum Substrat (1) fixierten Spiegel (Sp) umgelenkten Anteil (18) dieser Welle unter verschiedenen Einfallswinkeln belichtet wird.

**Claims**

1. Method for generating a lattice structure with a phase shift in a photosensitive surface layer (2, 11) on a substrate (1), the photosensitive surface layer (2, 11) being exposed in an interference field of two coherent light waves which has in a specific direction (Z) parallel to the photosensitive surface layer (2, 11) a specific spatial frequency (K+ΔK; K-ΔK) differing from zero, the photosensitive surface layer (2, 11) being exposed in at least one further interference field of two coherent light waves which has in the specific direction (Z) a spatial frequency (K-ΔK; K+ΔK) differing from zero and from the specific spatial frequency (K+ΔK; K-ΔK), and the photosensitive surface layer (2, 11) being developed after the exposures in these interference fields.

2. Method according to Claim 1, characterised in that the photosensitive surface layer of the substrate (1) comprises a photoresist layer (2) which is applied to the substrate (1) and is developed after the superimposed exposures, the surface (11), covered by the developed photoresist layer, of the substrate being etched by an etchant which attacks the surface (11) of the substrate.

3. Method according to Claim 1, characterised in that the photosensitive surface layer comprises the substrate surface (11), which is in contact with an etchant (20) and on which the etching reaction can be activated by exposure.

4. Method according to one of the preceding claims, characterised in that the photosensitive surface layer (2, 11) is exposed at different angles of incidence in the interference field (34) of two plane coherent waves (3, 4).

5. Method according to one of Claims 1 to 3, characterised in that the photosensitive surface layer (2, 11) is exposed in the interference field (56) of two divergent coherent light waves (5, 6) at different distances from the source points or source lines ($Q_5$, $Q_6$) of the divergent waves (5, 6).

6. Method according to one of Claims 1 to 3, characterised in that the photosensitive surface layer (2, 11) is exposed at different angles of incidence in the interference field (80) of a plane wave (8) and a portion (18) of this wave that is deflected by a mirror (Sp) fixed relative to the substrate (1).

**Revendications**

**1.** Procédé pour produire une structure de grille à saut de phase dans une couche superficielle photosensible (2,11) sur un substrat (1),

selon lequel la couche superficielle photosensible (2,11) est éclairée dans un champ d'interférences de deux ondes lumineuses cohérentes, qui possède, dans une direction déterminée (Z) parallèle à la couche superficielle photosensible (2,11), une fréquence locale déterminée (K + ΔK; K-ΔK) différente de zéro,

la couche superficielle photosensible (2,11) étant irradiée dans au moins un second champ d'interférences de deux ondes lumineuses, qui possède dans la direction déterminée (Z) une fréquence locale K-ΔK; K + ΔK différente de zéro ainsi que la fréquence locale prédéterminée K + ΔK; K-ΔK, et

la couche superficielle photosensible (2,11) étant développée après les expositions exécutées dans ces champs d'interférences.

**2.** Procédé suivant la revendication 1, caractérisé par le fait que la couche superficielle photosensible du substrat (1) est constituée par une couche de laque photosensible (2) disposée sur le substrat (1) et qui est développée après les expositions superposées, la surface (11) du substrat, qui est recouverte par la couche de laque photosensible développée, étant corrodée à l'aide d'un agent corrosif qui attaque la surface (11) du substrat.

**3.** Procédé suivant la revendication 1, caractérisé par le fait que la couche superficielle photosensible est constituée par la surface du substrat (11), qui est en contact avec un agent corrosif (20) et au niveau de laquelle la réaction de corrosion peut être activée par exposition.

**4.** Procédé suivant l'une des revendications précédentes, caractérisé par le fait que la couche superficielle photosensible (2,11) est exposée dans le champ d'interférences (34) de deux ondes cohérentes planes (3,4) sous différents angles d'incidence.

**5.** Procédé suivant l'une des revendications 1 à 3, caractérisé par le fait que la couche superficielle photosensible (2,11) est éclairée dans le champ d'interférences (56) de deux ondes lumineuses cohérentes divergentes (5,6) à des distances différentes des points ou lignes d'origine ($Q_5$,$Q_6$) des ondes divergentes (5,6).

**6.** Procédé suivant l'une des revendications 1 à 3, caractérisé par le fait que la couche superficielle photosensible (2,11) est éclairée, dans le champ d'interférences (80) d'une onde plane (8) et d'une partie (18) de cette onde, qui est déviée par un miroir (Sp) fixé par rapport au substrat (1), sous différents angles d'incidence.

# FIG 1

# FIG 5

FIG 2

FIG 3

FIG 4